(19) Europäisches Patentamt
European Patent Office
Office européen des brevets

(11) **EP 2 527 788 A1**

(12) **EUROPEAN PATENT APPLICATION**

(43) Date of publication:
**28.11.2012 Bulletin 2012/48**

(51) Int Cl.:
***G01C 19/56*** *(2012.01)*

(21) Application number: **11004355.1**

(22) Date of filing: **26.05.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **MAXIM INTEGRATED PRODUCTS, INC.**
**Sunnyvale, California 94086 (US)**

(72) Inventors:
• **Kondylis, Demetre**
  **Los Gatos**
  **95032 (US)**
• **Cazzaniga, Gabriele**
  **20088 Rosate (IT)**
• **Santoro, Manuel**
  **20143 Milano (IT)**
• **Coronato, Luca**
  **20094 Corsico (IT)**
• **Caminada, Carlo**
  **20010 Pregnan Milanese (IT)**
• **Prandi, Luciano**
  **28043 Bellinzago Novarese (IT)**

(74) Representative: **Jehle, Volker Armin et al**
  **Bosch Jehle Patentanwaltsgesellschaft mbH**
  **Flüggenstrasse 13**
  **80639 München (DE)**

(54) **Quadrature error compensation**

(57)    Certain embodiments of the invention relate to gyroscope devices, and / or to methods and systems for quadrature error correction, e.g., in gyroscope devices. The gyroscope may e.g. comprise a device for quadra-ture error correction adapted to compensate a quadrature signal charge injected on a rotor by injecting on the rotor an opposite charge using another electrode, and/or another couple of electrodes.

| Ideal system | Real system |
|---|---|

If $\Omega=0 \rightarrow \Delta y=0$ : no sense output   If $\Omega=0 \rightarrow \Delta y \neq 0$ : spurious sense output

| • Rot: | Rotor (moving mass) | •Ω: | Angular Rate |
|---|---|---|---|
| • D: | Driving electrodes | •x: | driving direction |
| • DS: | Drive Sense electrodes | •y: | sensing direction |
| • S: | Sense electrodes | | |

Fig. 1

**Description**

FIELD OF THE INVENTION

Certain embodiments of the invention relate to gyroscope devices, and / or to methods and systems for quadrature error correction, e.g., in gyroscope devices.

BACKGROUND OF THE INVENTION

In gyroscope devices, a problem to be solved is the occurrence of a quadrature error. A quadrature error may e.g. be a spurious signal superimposed to a useful angular rate signal.
Quadrature error is due to imperfections and asymmetries in the geometry of the moving mass of a gyroscope device. The amplitude of such a quadrature error can be $10 \div 100$ times the typical gyroscope full scales.
The performance of a gyroscope device is affected by quadrature error e.g. in the following parameters:

- Charge amplifier dynamic range;
- Output noise; and/or
- Zero Rate Level temperature drift

Further limitations and disadvantages of conventional and traditional approaches will become apparent to one of skill in the art, through comparison of such methods and systems with some aspects of the present invention as set forth in the remainder of the present application with reference to the drawings.

BRIEF SUMMARY OF THE INVENTION

A system and/or method is provided for quadrature error correction, substantially as shown in and/or described in connection with at least one of the figures, as set forth more completely in the claims. These and other advantages, aspects and novel features of the present invention, as well as details of an illustrated embodiment thereof, will be more fully understood from the following description and drawings.

BRIEF DESCRIPTION OF SEVERAL VIEWS OF THE DRAWINGS

FIG.1 is a diagram illustrating how a quadrature error arises in a capacitive gyroscope.
FIG. 2 is a diagram illustrating a sense read out.
FIG. 3 is a diagram illustrating a proposed solution for quadrature signal compensation, in accordance with an embodiment of the invention.
FIG. 4 is a diagram illustrating a sense read out with a quadrature signal compensation, in accordance with an embodiment of the invention.
Fig. 5 is a diagram illustrating a closed loop quadrature signal compensation, in accordance with an embodiment of the invention.

DETAILED DESCRIPTION OF THE INVENTION

Certain embodiments of the invention may be found in a method and system for for quadrature error correction, for example in, but not limited to gyroscope devices.

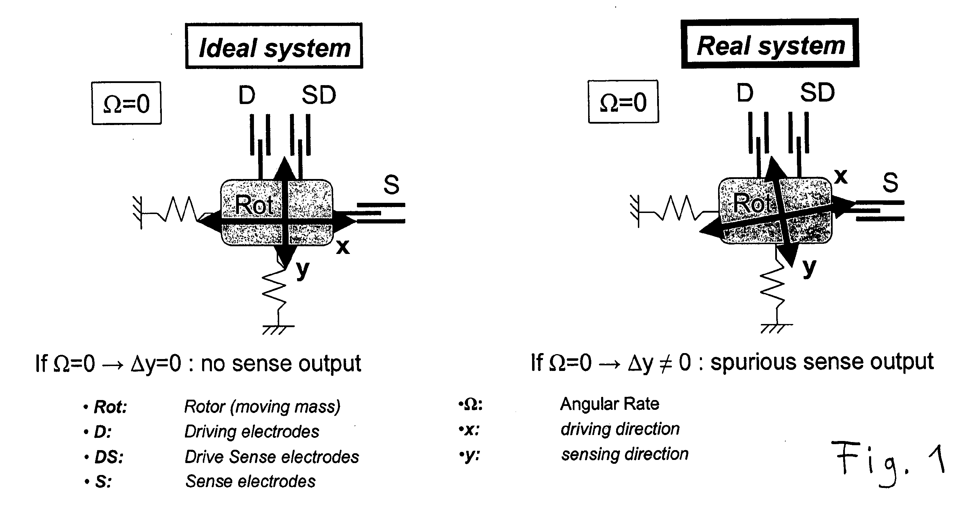

FIG. 1 is a diagram illustrating how a quadrature error arises in a capacitive gyroscope.
In Figure 1, "Rot" denotes the Rotor (moving mass), "D" the Driving electrodes, "DS" the Drive Sense electrodes, "S" the Sense electrodes, "$\Omega$" the Angular Rate, "x" the driving direction, and "y" the sensing direction.
As can be seen in Figure 1, in an ideal system, if $\Omega=0 \rightarrow \Delta y=0$. Hence, no sense output occurs.
In contrast, in a real system, if $\Omega=0 \rightarrow \Delta y \neq 0$. Hence, a spurious sense output occurs.

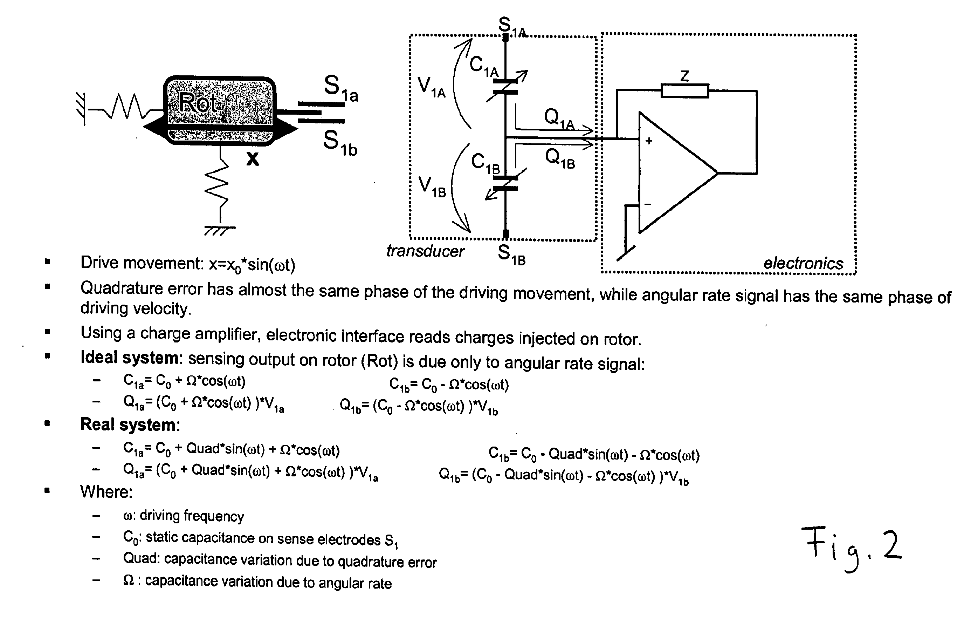

FIG. 2 is a diagram illustrating a sense read out, in particular, for the real and ideal systems shown in Figure 1. As is shown in Figure 2, the respective drive movement is: $x=x0*\sin(\omega t)$.
The quadrature error has almost the same phase of the driving movement, while the angular rate signal has the same phase of driving velocity. As further follows from Figure 2, using a charge amplifier, an electronic interface reads charges injected on rotor.
In the ideal system, the sensing output on rotor (Rot) is due only to angular rate signal:

$$-C_{1a}= C_0 + \Omega^*\cos(\omega t) \qquad C_{1b}= C_0 - \Omega^*\cos(\omega t)$$

$$-Q_{1a}= (C_0 + \Omega^*\cos(\omega t))^*V_{1a} \qquad Q_{1b}= (C_0 - \Omega^*\cos(\omega t))^*V_{1b}$$

In contrast thereto, in a real system:

$$-C_{1a}= C_0 + Quad^*\sin(\omega t) + \Omega^*\cos(\omega t) \qquad C_{1b}= C_0 - Quad^*\sin(\omega t) - \Omega^*\cos(\omega t)$$

$$-Q_{1a}= (C_0 + Quad^*\sin(\omega t) + \Omega^*\cos(\omega t))^*V_{1a} \qquad Q_{1b}= (C_0 - Quad^*\sin(\omega t) - \Omega^*\cos(\omega t))^*V_{1b}$$

Thereby, "w" denotes the driving frequency, "$C_0$" the static capacitance on sense electrodes S1, "Quad" the capacitance variation due to quadrature error, and "$\Omega$" the capacitance variation due to angular rate.

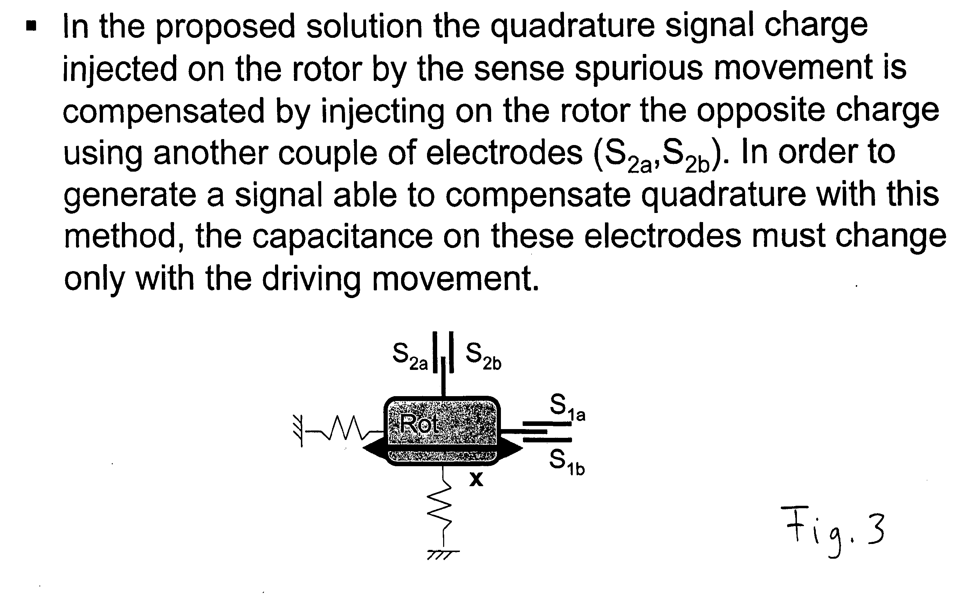

Fig. 3 is a diagram illustrating a proposed solution for quadrature signal compensation, in accordance with an embodiment of the invention.

In the proposed solution the quadrature signal charge injected on the rotor by the sense spurious movement is compensated by injecting on the rotor the opposite charge using another couple of electrodes ($S_{2a}, S_{2b}$). In order to generate a signal able to compensate quadrature with this method, the capacitance on these electrodes must change only with the driving movement.

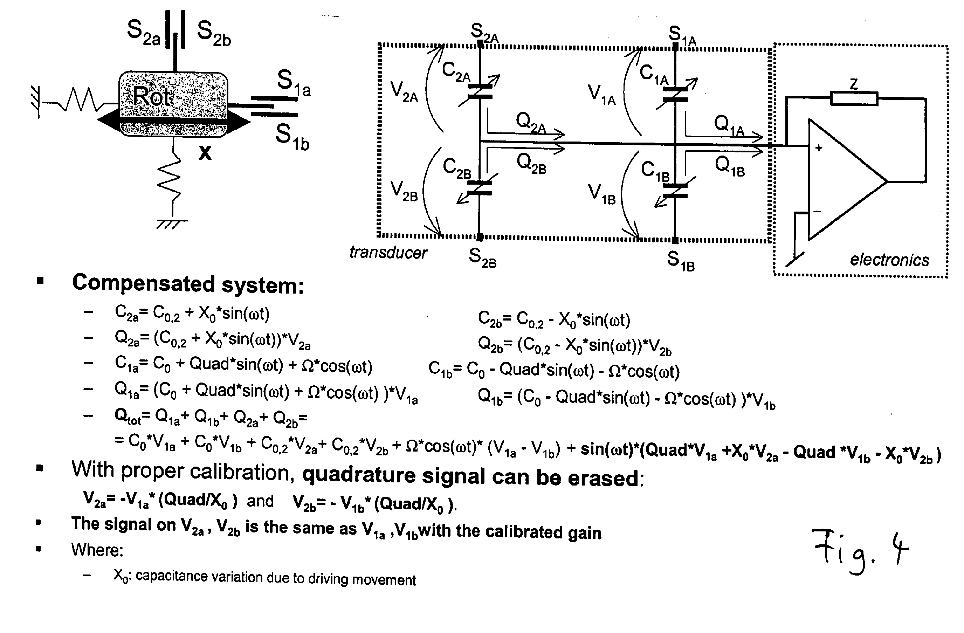

FIG. 4 is a diagram illustrating a sense read out with a quadrature signal compensation, in accordance with an embodiment of the invention.

As follows from Fig. 4, in the compensated system:

$$-C_{2a}= C_{0,2} + X_0^*\sin(\omega t) \qquad C_{2b}= C_{0,2} - X_0^*\sin(\omega t)$$

$$-Q_{2a}= (C_{0,2} + X_0^*\sin(\omega t))^*V_{2a} \qquad Q_{2b}= (C_{0,2} - X_0^*\sin(\omega t))^*V_{2b}$$

$$-C_{1a}= C_0 + Quad^*\sin(\omega t) + \Omega^*\cos(\omega t) \qquad C_{1b}= C_0 - Quad^*\sin(\omega t) - \Omega^*\cos(\omega t)$$

$$-Q_{1a}= (C_0 + Quad^*\sin(\omega t) + \Omega^*\cos(\omega t))^*V_{1a} \qquad Q_{1b}= (C_0 - Quad^*\sin(\omega t) - \Omega^*\cos(\omega t))^*V_{1b}$$

$$-Q_{tot}= Q_{1a} + Q_{1b} + Q_{2a} + Q_{2b} =$$
$$= C_0^*V_{1a} + C_0^*V_{1b} + C_{0,2}^*V_{2a} + C_{0,2}^*V_{2b} + \Omega^*\cos(\omega t)^* (V_{1a} - V_{1b}) + \sin(\omega t)^*(Quad^*V_{1a} + X_0^*V_{2a} - Quad^*V_{1b} - X_0^*V_{2b})$$

Hence, with proper calibration, the quadrature signal can be erased:

$$V_{2a}= -V_{1a}^* (Quad/X_0) \quad \text{and} \quad V_{2b}= -V_{1b}^* (Quad/X_0)$$

The signal on $V_{2a}$, $V_{2b}$ is the same as $V_{1a}$, $V_{1b}$ with the calibrated gain.

$X_0$ is the capacitance variation due to the driving movement.

The proposed solution needs an electrode which is able to read the drive movement. This electrode can be:

- A dedicated electrode.
- The same electrode which is already present on the gyroscope for the driving loop, to sense the driving movement (SD).

- The same electrode which is already present on the gyroscope for the driving loop, to force the driving movement (D).

The solution is suitable for 1x, 2x or 3x gyroscopes. In multi-axis gyroscope each sense axis needs a different calibration voltage. The compensation signals can be applied to different electrodes (1 for each sensing axis) or on the same electrode for all axes (summing the different compensation signals).

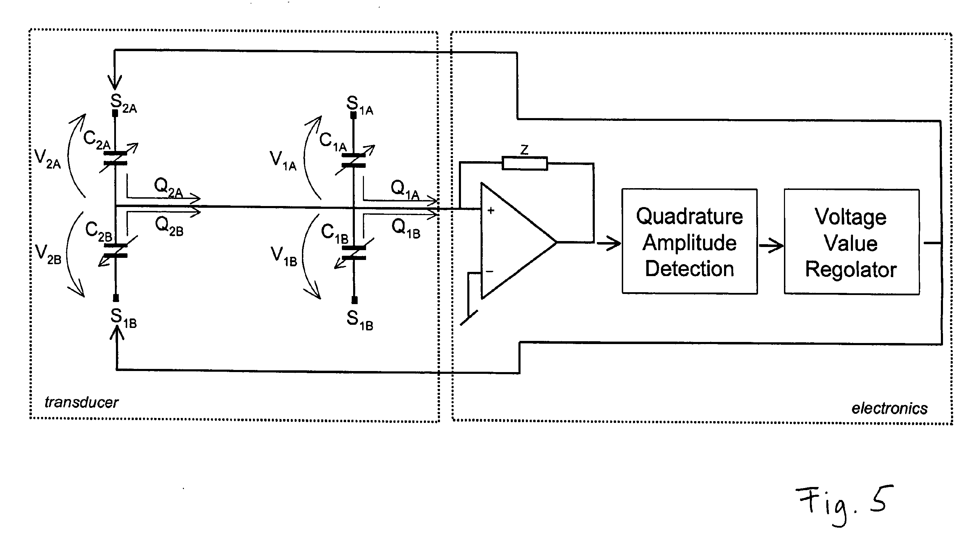

The compensation voltage can be changed during working of the device to perform closed loop adaptive control of quadrature error. In this case, quadrature error drift during lifetime can be compensated as well (see also Fig. 5, which illustrates a closed loop quadrature signal compensation, in accordance with an embodiment of the invention).

While the present invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiment disclosed, but that the present invention will include all embodiments falling within the scope of the appended claims.

**Claims**

1.  A gyroscope, comprising a device for quadrature error correction.

2.  The gyroscope of claim 1, wherein the device for quadrature error correction is adapted to compensate a quadrature signal charge injected on a rotor by injecting on the rotor an opposite charge using another electrode, and/or another couple of electrodes.

3.  A method for quadrature error correction in a gyroscope.

4.  The method of claim 3, comprising: compensating a quadrature signal charge injected on a rotor by injecting on the rotor an opposite charge using another electrode, and/or another couple of electrodes.

5.  A method for quadrature error correction, comprising one or several of the features or combination of features shown in Figures 1 - 5, and/or or described in connection with these Figures.

6.  A system for quadrature error correction, comprising one or several of the features or combination of features shown in Figures 1 - 5, and/or or described in connection with these Figures.

**Ideal system**

$\Omega=0$

D  SD

Rot

S

x

y

If $\Omega=0 \rightarrow \Delta y=0$ : no sense output

- **Rot:**  Rotor (moving mass)
- **D:**  Driving electrodes
- **DS:**  Drive Sense electrodes
- **S:**  Sense electrodes

**Real system**

$\Omega=0$

D  SD

Rot

x

S

y

If $\Omega=0 \rightarrow \Delta y \neq 0$ : spurious sense output

- $\cdot\Omega$:  Angular Rate
- $\cdot x$:  driving direction
- $\cdot y$:  sensing direction

Fig. 1

EP 2 527 788 A1

*transducer* $S_{1B}$     *electronics*

- Drive movement: $x = x_0 * \sin(\omega t)$
- Quadrature error has almost the same phase of the driving movement, while angular rate signal has the same phase of driving velocity.
- Using a charge amplifier, electronic interface reads charges injected on rotor.
- **Ideal system**: sensing output on rotor (Rot) is due only to angular rate signal:
  - $C_{1a} = C_0 + \Omega^* \cos(\omega t)$        $C_{1b} = C_0 - \Omega^* \cos(\omega t)$
  - $Q_{1a} = (C_0 + \Omega^* \cos(\omega t))^* V_{1a}$     $Q_{1b} = (C_0 - \Omega^* \cos(\omega t))^* V_{1b}$
- **Real system**:
  - $C_{1a} = C_0 + \text{Quad}^* \sin(\omega t) + \Omega^* \cos(\omega t)$     $C_{1b} = C_0 - \text{Quad}^* \sin(\omega t) - \Omega^* \cos(\omega t)$
  - $Q_{1a} = (C_0 + \text{Quad}^* \sin(\omega t) + \Omega^* \cos(\omega t))^* V_{1a}$     $Q_{1b} = (C_0 - \text{Quad}^* \sin(\omega t) - \Omega^* \cos(\omega t))^* V_{1b}$
- Where:
  - $\omega$: driving frequency
  - $C_0$: static capacitance on sense electrodes $S_1$
  - Quad: capacitance variation due to quadrature error
  - $\Omega$: capacitance variation due to angular rate

Fig. 2

EP 2 527 788 A1

- In the proposed solution the quadrature signal charge injected on the rotor by the sense spurious movement is compensated by injecting on the rotor the opposite charge using another couple of electrodes ($S_{2a}$, $S_{2b}$). In order to generate a signal able to compensate quadrature with this method, the capacitance on these electrodes must change only with the driving movement.

Fig. 3

EP 2 527 788 A1

EP 2 527 788 A1

*transducer*     *electronics*

- **Compensated system:**
  - $C_{2a} = C_{0,2} + X_0*\sin(\omega t)$     $C_{2b} = C_{0,2} - X_0*\sin(\omega t)$
  - $Q_{2a} = (C_{0,2} + X_0*\sin(\omega t))*V_{2a}$     $Q_{2b} = (C_{0,2} - X_0*\sin(\omega t))*V_{2b}$
  - $C_{1a} = C_0 + \text{Quad}*\sin(\omega t) + \Omega*\cos(\omega t)$     $C_{1b} = C_0 - \text{Quad}*\sin(\omega t) - \Omega*\cos(\omega t)$
  - $Q_{1a} = (C_0 + \text{Quad}*\sin(\omega t) + \Omega*\cos(\omega t))*V_{1a}$     $Q_{1b} = (C_0 - \text{Quad}*\sin(\omega t) - \Omega*\cos(\omega t))*V_{1b}$
  - $Q_{tot} = Q_{1a} + Q_{1b} + Q_{2a} + Q_{2b} =$

    $= C_0*V_{1a} + C_0*V_{1b} + C_{0,2}*V_{2a} + C_{0,2}*V_{2b} + \Omega*\cos(\omega t)*(V_{1a} - V_{1b}) + \sin(\omega t)*(\text{Quad}*V_{1a} + X_0*V_{2a} - \text{Quad}*V_{1b} - X_0*V_{2b})$

- With proper calibration, **quadrature signal can be erased**:

  $V_{2a} = -V_{1a}*(\text{Quad}/X_0)$ and   $V_{2b} = -V_{1b}*(\text{Quad}/X_0)$.

- **The signal on $V_{2a}$, $V_{2b}$ is the same as $V_{1a}$, $V_{1b}$ with the calibrated gain**

- Where:
  - $X_0$: capacitance variation due to driving movement

*Fig. 4*

Fig. 5

Europäisches
Patentamt

European
Patent Office

Office européen
des brevets

**EUROPEAN SEARCH REPORT**

Application Number

EP 11 00 4355

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 6 067 858 A (CLARK WILLIAM A [US] ET AL) 30 May 2000 (2000-05-30)<br>* figures 1,7A-C,16,17A *<br>* column 4, lines 28-40 *<br>* column 7, line 8 - column 8, line 47 *<br>* column 15, line 51 - column 16, line 2 *<br>* column 18, lines 26-36 *<br>----- | 1-6 | INV.<br>G01C19/56 |
| X | EP 1 752 733 A2 (LITTON SYSTEMS INC [US]) 14 February 2007 (2007-02-14)<br>* the whole document *<br>----- | 1-6 | |
| X | US 2006/213265 A1 (WEBER MARK W [US] ET AL) 28 September 2006 (2006-09-28)<br>* the whole document *<br>----- | 1-6 | |
| X | US 2010/132461 A1 (HAUER JOERG [DE] ET AL) 3 June 2010 (2010-06-03)<br>* the whole document *<br>----- | 1-6 | |
| | | | **TECHNICAL FIELDS SEARCHED (IPC)**<br><br>G01C |

The present search report has been drawn up for all claims

| Place of search | Date of completion of the search | Examiner |
|---|---|---|
| The Hague | 4 October 2011 | Faivre, Olivier |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 11 00 4355

This annex lists the patent family members relating to the patent documents cited in the above-mentioned European search report.
The members are as contained in the European Patent Office EDP file on
The European Patent Office is in no way liable for these particulars which are merely given for the purpose of information.

04-10-2011

| Patent document cited in search report | | Publication date | Patent family member(s) | | Publication date |
|---|---|---|---|---|---|
| US 6067858 | A | 30-05-2000 | AU | 3474497 A | 05-01-1998 |
| | | | DE | 69735759 T2 | 02-11-2006 |
| | | | EP | 0902876 A1 | 24-03-1999 |
| | | | JP | 2002515976 A | 28-05-2002 |
| | | | WO | 9745699 A2 | 04-12-1997 |
| | | | US | 5992233 A | 30-11-1999 |
| EP 1752733 | A2 | 14-02-2007 | JP | 2007047166 A | 22-02-2007 |
| US 2006213265 | A1 | 28-09-2006 | US | 2006213266 A1 | 28-09-2006 |
| US 2010132461 | A1 | 03-06-2010 | DE | 102008044053 A1 | 27-05-2010 |

EPO FORM P0459

For more details about this annex : see Official Journal of the European Patent Office, No. 12/82